# EUROPEAN PATENT SPECIFICATION

(11) **EP 0 387 638 B1**
(45) Date of publication and mention of the grant of the patent: **25.05.1994**
(21) Application number: 90104123.6
(22) Date of filing: 02.03.1990
(51) Int. Cl.: C01B 33/107, C30B 25/02, C30B 29/06

(54) **Purification of chlorosilanes**
Reinigung von Chlorsilanen
Purification de chlorosilanes

(30) Priority: 14.03.1989 US 323473
(43) Date of publication of application: 19.09.1990
(73) Proprietor: HERCULES INCORPORATED, Wilmington Delaware 19894 (US)
(72) Inventor: Bartell, Don G., Chadds Ford, Pennsylvania 19317 (US); Weber, Daniel K., Livermore, California 94550 (US)
(74) Representative: Lederer, Franz, Dr.

(56) References cited:
- GB-A- 1 015 604

## Description

This invention relates to the purification of dichlorosilanes.

Many high performance semiconductor devices require high resistivity epitaxial silicon films. The epitaxial growth process is a means of depositing a thin layer (0.5 to 20 microns) of single crystal material on the surface of a single crystal substrate, for example, silicon. The electrical properties of single crystal silicon are extremely sensitive to impurities. Resistivity, for example, is a measure of the resistance to the flow of electrical current and is a function of the concentration of charge carriers (dopants) in a semiconductor.

There are four major chemical sources of silicon used commercially for epitaxial deposition, namely silicon tetrachloride (SiCl₄), trichlorosilane (SiHCl₃), dichlorosilane (SiH₂Cl₂) and silane (SiH₄). Each of these sources has properties that makes it attractive under particular deposition conditions and for specific film requirements. Deposition involves disproportionation of the chlorosilane at an elevated temperature to form silicon and HCl, usually in the presence of hydrogen as a reductant. GB-A-1,015,604 describes a process for the removal of phosphorus trichloride from trichlorosilane or silicon tetrachloride by treating the halogen substituted derivative of silane with an adsorbent substance comprising aluminia coated with platinum tetrachloride. Demands for thinner epitaxial layers and deposition at a lower temperature have led to increased use of SiH₂Cl₂, which can be deposited at 1050-1150°C, compared with 1150-1250°C for silicon tetrachloride and 1100-1200°C for trichlorosilane. However, dichlorosilane is typically contaminated with 1-5 parts per billion of dopants, such as arsenic, phosphorus and boron. These dopants limit the resistivity, and therefore the performance, of epitaxial silicon films in high performance devices. Normal analytical chemical methods cannot reliably detect and measure these low levels of impurities. Suppliers typically determine the impurity levels of the gas that is used as the silicon source by converting the gas to polycrystalline silicon, then float zone refining the silicon into a single crystal whose resistivity is measured. High resistivities indicate high purity of the source gas. Alternatively, the source gas is converted to an epitaxial silicon film for the determination of resistivity. Epitaxial silicon films deposited from commercially available dichlorosilane, for example, typically have a resistivity of 50-100 ohm-cm.

The dichlorosilane available at the present time is typically purified by the supplier by fractional distillation. However, it is not convenient to use this method at the point-of-use of the dichlorosilane. In addition, the last traces of impurities cannot easily be removed by this method.

It is also known to use active alumina adsorbents having electrophilic and/or nucleophilic properties to purify chlorosilanes (Danish patent 100,224 to H. F. A. Topsoee). However, contacting dichlorosilane with alumina results in an exotherm in excess of 100°C. This large exotherm would not be acceptable to a potential user of dichlorosilane for safety reasons and because the reaction of the dichlorosilane with the alumina could generate products that would cause contamination of process equipment.

The process of this invention for removing impurities from dichlorosilanes is characterized in that the dichlorosilane is contacted with a chloride of silicon, titanium, zirconium or tungsten, which is immobilized on an inorganic solid support.

This process avoids the production of large exotherms and can be employed at the point-of-use of the chlorosilane.

Suitable chlorides that can be immobilized on a solid support for use in the process of this invention include chlorides of silicon, titanium, zirconium and tungsten.

Silicon tetrachloride is preferred when the dichlorosilane is used for the deposition of epitaxial silicon films, in order to avoid the possible introduction of metal compounds that could act as impurities in the silicon film.

Chlorides such as SiCl₄ and TiCl₄ are immobilized by reacting them in the liquid state with the solid support, or by heating to vaporize them before contact with the support. Solid chlorides such as WCl₆ and ZrCl₄ can be dissolved in a suitable solvent such as toluene or heated and sublimed under low pressure before contact with the support. In order to prevent the emission of any loosely bound chloride into the purified dichlorosilane, the support with the immobilized chloride on its surface should preferably be heated to a temperature of about 190°C under nitrogen until no volatiles can be detected. The time required will depend upon the space velocity of the nitrogen purge and the size and geometry of the reactor. The lower the space velocity of the nitrogen, the longer the time required to remove volatiles.

Suitable inorganic solid supports include, but are not limited to, alumina, silica-alumina and crystalline metal alumino-silicates. Alumina is preferred.

The purifiers of this invention can be employed to remove trace amounts of impurities from commercially available dichlorosilane, when the dichlorosilanes are used to prepare high resistivity epitaxial silicon films. For example, when dichlorosilane purified by the process of this invention is used to prepare epitaxial silicon films, the resistivity of the silicon film is greater than 100 ohm-cm, as measured by spreading resistance probe. In addition to their use for the deposition of epitaxial silicon films, the purified chlorosilanes can also be used in the manufacture of various silicon compounds such as silicon dioxide, silicon nitride and silicon carbide.

### Example 1

A purifier comprising silicon tetrachloride immobilized on an alumina support is prepared as follows. One gallon (3.7 ℓ) of a spherical desiccant grade of alumina is heated at 250°C for 30 hours under a purge of dry nitrogen. The resulting dehydrated alumina is functionalized with 400 ml of silicon tetrachloride, introduced as a vapor in a nitrogen carrier gas. The product is heated to 190°C under a purge of dry nitrogen for 50 hours. The product is then transferred under an atmosphere of dry nitrogen to a 0.5 liter device suitable for fitting onto the dichlorosilane delivery line of an epitaxial silicon reactor.

Before fitting onto the dichlorosilane delivery line, the silicon tetrachloride/alumina purifier is treated with flowing dichlorosilane. The dichlorosilane is initially adsorbed, as indicated by the absence of dichlorosilane in the exit gas. When no more dichlorosilane is adsorbed, dichlorosilane appears in the exit gas. This event is referred to as "the breakthrough point".

The treated purifier is then employed to purify dichlorosilane that is to be used to grow an undoped epitaxial silicon film on two inch (5 cm) antimony-doped silicon wafers. Prior to deposition of the epitaxial film, the doped silicon wafers are given an in-situ etch at 1120°C with hydrogen chloride. The purified dichlorosilane is disproportionated at 1070°C using 60-80 liters/min of hydrogen as a reductant and purge gas. The dichlorosilane flow rate is approximately 1 liter/min. The epitaxial film that is deposited has a thickness of 13-15 microns. As a control, epitaxial silicon films are prepared under identical conditions without purifying the dichlorosilane. The resistivities of the films, as measured by both mercury probe and spreading resistance probe, are given in Table 1.

**Table 1**

| Sample | Purifier | Resistivity (ohm-cm) | |
|---|---|---|---|
| | | Mercury Probe | Spreading Resistance |
| 1 | no | 40 | 45 |
| 2 | no | 42 | 60 |
| 3 | yes | 300 | 120 |
| 4 | yes | 350 | 160 |

### Example 2

Films of epitaxial silicon are deposited on a silicon substrate by disproportionation of commercially available dichlorosilane, and dichlorosilane that has been purified by contacting with the silicon tetrachloride/alumina purifier prepared as described in Example 1. The resistivity of the epitaxial silicon film deposited from the commercially available dichlorosilane is 5 ohm-cm, as measured by spreading resistance probe. When purified dichlorosilane is used, the resistivity of the epitaxial film is 400 ohm-cm.

### Example 3

This example compares the magnitude of the exotherm encountered when contacting dichlorosilane with alumina alone and with the silicon tetrachloride/alumina purifier prepared as described in Example 1.

The silicon tetrachloride/alumina purifier (75 ml) is contacted with dichlorosilane at a flow rate of 0.11 liters/min. An exotherm is detected by means of a thermocouple located in the center of the bed and the maximum temperature attained is 50°C. Breakthrough of dichlorosilane occurs after 15 minutes. Following exposure to dichlorosilane, the sample is thoroughly purged with helium at 1 liter/min in order to displace adsorbed, unreacted dichlorosilane. Exposure to dichlorosilane at 0.11 liter/min for a second time gives a maximum temperature of 45.2°C. Breakthrough of dichlorosilane takes place after 15 minutes. The initial and subsequent adsorption of dichlorosilane are virtually identical, corresponding to 0.90 mole of dichlorosilane per liter of sample. The close correspondence of the initial and subsequent adsorption experiments demonstrates that virtually all of the adsorption of dichlorosilane is reversible, i.e., no reaction has taken place between the dichlorosilane and the purifier.

For comparison, alumina (500 ml) is heated to 250°C in a flow of dry nitrogen for 6 hours. Dichlorosilane is contacted with 75 ml of the alumina at a flow rate of 0.11 liter/min. The temperature is measured with a thermocouple located in the center of the bed and the maximum temperature attained is 138°C. Breakthrough of dichlorosilane is detected after 19 minutes. The sample is thoroughly purged with 1 liter/min of helium. Subsequent exposure to dichlorosilane at 0.11 liter/min gives a maximum temperature of 40.6°C. Breakthrough of dichlorosilane takes place in 16 minutes. The initial adsorption of dichlorosilane is 1.14 liters of dichlorosilane/liter of alumina. The subsequent adsorption of dichlorosilane is 0.96 mole of dichlorosilane/liter of sample. By difference, the irreversible component of adsorption is 0.18 mole of dichlorosilane per liter of sample, i.e., some of the dichlorosilane has reacted with the alumina.

## Claims

1. A process for removing impurities from dichlorosilane, characterized in that the dichlorosilane is contacted with a chloride of silicon, titanium, zirconium or tungsten, that is immobilized on an inorganic solid support.

2. The process as claimed in claim 1, further characterized in that the chloride is silicon tetrachloride and the support is alumina.

3. Process for the preparation of epitaxial silicon films having a resistivity of greater than 100 ohm-cm as measured by spreading resistance probe by disproportionation of a dichlorosilane at an elevated temperature, characterized in that the dichlorosilane is purified by the process of claim 2.

## Patentansprüche

1. Verfahren zur Entfernung von Verunreinigungen von Dichlorsilan, dadurch gekennzeichnet, daß das Dichlorsilan mit einem Chlorid von Silicium, Titan, Zirconium oder Wolfram in Kontakt kommt, das auf einem anorganischen festen Träger immobilisiert wird.

2. Verfahren nach Anspruch 1, weiterhin dadurch gekennzeichnet, daß das Chlorid Siliciumtetrachlorid und der Träger Aluminiumoxid ist.

3. Verfahren zur Herstellung von epitaxialen Siliciumfilmen, die einen spezifischen Widerstand größer als 100 Ohm-cm aufweisen, gemessen durch Bahnwiderstand-Sonde, durch Disproportionierung eines Dichlorsilans bei erhöhter Temperatur, dadurch gekennzeichnet, daß das Dichlorsilan durch das Verfahren nach Anspruch 2 gereinigt wird.

## Revendications

1. Procédé pour éliminer des impuretés du dichlorosilane, caractérisé en ce que l'on met le dichlorosilane en contact avec un chlorure de silicium, de titane, de zirconium ou de tungstène, qui est immobilisé sur un support inorganique solide.

2. Procédé suivant la revendication 1, caractérisé en ce que le chlorure est le tétrachlorure de silicium et le support est l'alumine.

3. Procédé de préparation de films de silicium épitaxiaux possédant une résistivité supérieure à 100 ohms-cm, telle que mesurée par une sonde de résistance répartie ou de diffusion par dismutation d'un dichlorosilane à température élevée, caractérisé en ce que le dichlorosilane est purifié par mise en oeuvre du procédé suivant la revendication 2.
